(19) Europäisches Patentamt
European Patent Office
Office européen des brevets

(11) EP 4 060 719 A1

(12) DEMANDE DE BREVET EUROPEEN

(43) Date de publication:
21.09.2022 Bulletin 2022/38

(21) Numéro de dépôt: 22162742.5

(22) Date de dépôt: 17.03.2022

(51) Classification Internationale des Brevets (IPC):
H01L 21/66 (2006.01)    G06N 20/00 (2019.01)

(52) Classification Coopérative des Brevets (CPC):
H01L 22/12; G06N 20/00; H01L 22/20; H01L 22/14

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR
Etats d'extension désignés:
BA ME
Etats de validation désignés:
KH MA MD TN

(30) Priorité: 18.03.2021 FR 2102722

(71) Demandeur: Commissariat à l'Energie Atomique et aux Energies Alternatives
75015 Paris (FR)

(72) Inventeurs:
• VIEY, Abygael
  38054 GRENOBLE CEDEX 09 (FR)
• GARROS, Xavier
  38054 GRENOBLE CEDEX 09 (FR)
• GERRER, Louis
  38054 GRENOBLE CEDEX 09 (FR)
• VANDENDAELE, William
  38054 GRENOBLE CEDEX 09 (FR)

(74) Mandataire: Cabinet Camus Lebkiri
25 rue de Maubeuge
75009 Paris (FR)

(54) **PROCÉDÉ DE DÉTERMINATION D'UNE CARTOGRAPHIE CET, PROCÉDÉ DE DÉTERMINATION DE L'ÉNERGIE D'ACTIVATION D'UN TYPE DE DÉFAUTS ET DISPOSITIF ASSOCIÉ**

(57)    Un premier aspect de l'invention concerne un procédé de détermination d'une cartographie CET caractérisant le temps de capture et d'émission des pièges dans un transistor pour une tension de stress donnée et une température donnée, dite cartographie CET optimale, cette détermination se faisant à partir d'une mesure expérimentale de l'évolution temporelle du changement de la tension de seuil $V_{TH}$ pour la même tension de stress et la même température et à partir d'une fonction de distribution des pièges, ladite fonction de distribution pouvant être définie par $N_{par}$ paramètres. Plus particulièrement, le procédé selon le premier aspect de l'invention met en œuvre un algorithme génétique donc les paramètres sont mis à jour régulièrement afin d'optimiser le temps de calcul tout en diminuant le risque d'aboutir à un minimum local dans la détermination de la cartographie CET optimale. Un deuxième aspect de l'invention concerne un procédé de détermination de l'énergie d'activations d'un type de défauts dans un transistor.

[Fig. 4]

**Description**

**DOMAINE TECHNIQUE DE L'INVENTION**

Le domaine technique de l'invention est celui de la caractérisation des défauts dans un dispositif semi-conducteur.

La présente invention concerne un procédé de détermination d'une cartographie CET, en particulier d'un procédé permettant d'automatiser cette détermination au moyen d'un algorithme génétique. L'invention concerne également un procédé de détermination de l'énergie d'activation des défauts ainsi qu'un dispositif mettant en œuvre l'un de ces procédés.

**ARRIERE-PLAN TECHNOLOGIQUE DE L'INVENTION**

Lors du développement ou de la caractérisation d'un dispositif semi-conducteur, il est utile de pourvoir anticiper l'évolution de son comportement au cours du temps. C'est notamment vrai dans le cas des transistors à effet de champ qui peuvent voir leurs caractéristiques dériver dans le temps.

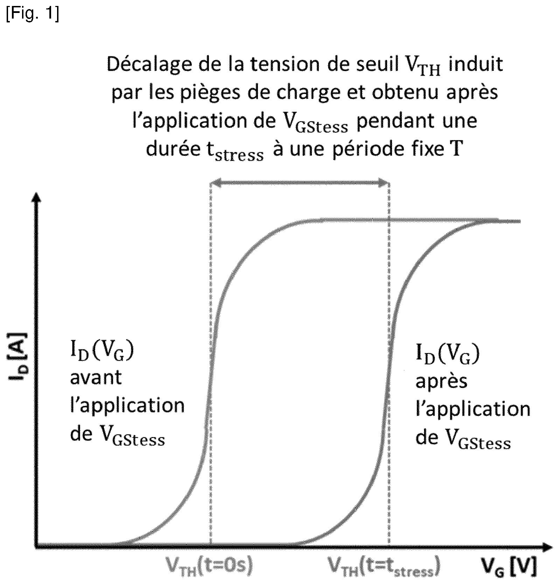

Un phénomène bien connu, appelé Bias Temperature Instability (BTI) en langue anglaise, décrit une instabilité ou un décalage de la tension de seuil $V_{TH}$ dépendant de la tension appliquée sur la grille du transistor $V_G$, et de la température $T$. En effet, lorsque l'on fait une première mesure $I_D(V_G)$ (où $I_D$ est le courant de drain) et que, par la suite, on applique une tension de grille non nulle $V_{GStress}$ pendant un certain temps $t_{Stress}$, on peut observer un décalage de caractéristique $I_D(V_G)$ lorsque l'on réalise une nouvelle fois la mesure $I_D(V_G)$. Ce décalage de caractéristique $I_D(V_G)$ se traduit alors par un décalage de tension de seuil $V_{TH}$. Un tel décalage est par exemple illustré à la [Fig. 1].

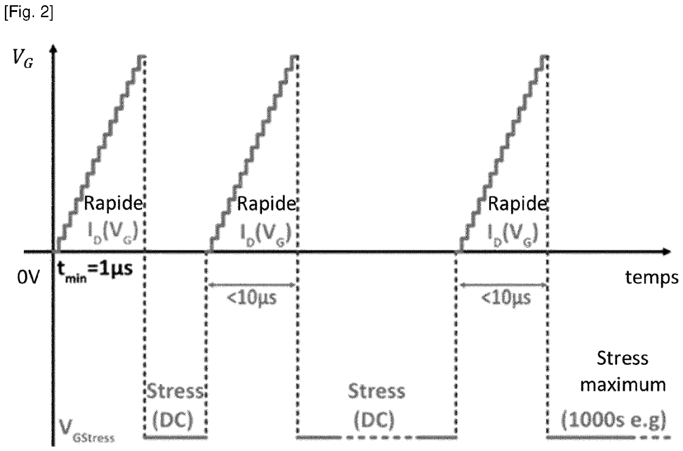

Une technique permettant de mesurer ce décalage de $V_{TH}$ lors du stress de grille est déjà connue : il s'agit de la procédure dite de Measurement-Stress-Measurement (MSM) en langue anglaise. Le stress est entrecoupé d'une mesure $I_D(V_G)$ ultra-rapide (<10µs) telle que l'extraction de $V_{TH}$ est possible. En effet, le décalage de la tension de seuil $V_{TH}$ a pour origine l'activation de pièges éléctroniques lors de l'application d'une tension de stress au niveau de la grille. Lors de la mesure MSM, la mesure ultrarapide ne donne pas à ces derniers le temps de relaxer comme illustré à la [Fig. 2].

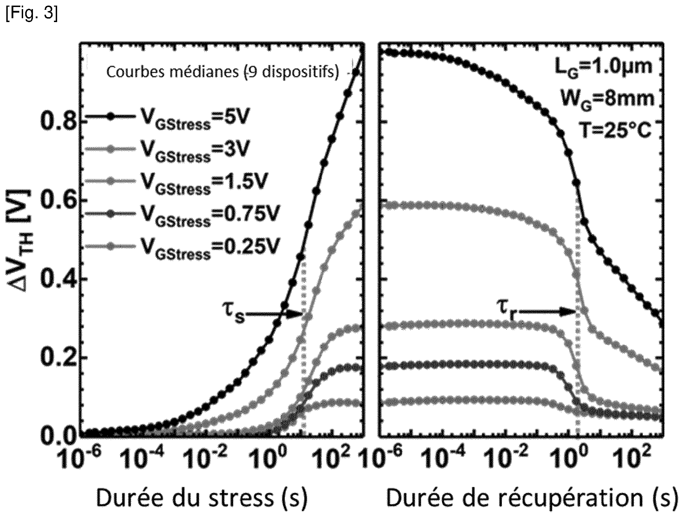

La procédure MSM permet ainsi d'obtenir des transitoires BTI ($\Delta V_{TH}(t)$) comme on peut le voir sur la [Fig. 3]. On peut y observer ces transitoires en phase de stress ($V_{GStress} \neq 0V$) et de recouvrement ($V_{GStress} = 0V$) intervenant juste après le stress. Dans cet exemple, on dira que l'on observe des transitoires pBTI car les tensions de stress appliquées sont positives. A l'inverse, quand on applique une tension de stress négative, on parlera de transitoire nBTI.

Lors de la mise au point d'un dispositif électronique, il est important de pouvoir rendre compte ces transitoires. De manière générale, il est déterminé une cartographie de la densité des pièges à l'origine du décalage de la tension de seuil (dite cartographie CET, pour Capture Emission Time en langue anglaise) et, à partir de cette cartographie CET, la variation de la tension de seuil en fonction de la durée du stress et de la durée de récupération. Cependant, la détermination d'une telle cartographie est très fastidieuse et prend donc beaucoup de temps. En outre, cette dernière est effectuée manuellement, ce qui rend différentes cartographies difficiles à comparer. De plus, compte tenu du temps nécessaire pour établir une telle cartographie, ce travail n'est en général effectué que pour une seule tension de stress et une seule température.

Il existe donc un besoin d'un procédé qui permette de déterminer rapidement et de manière automatique une cartographie CET.

**RESUME DE L'INVENTION**

L'invention offre une solution aux problèmes évoqués précédemment, en permettant, à partir de mesures expérimentales, de déterminer une cartographie CET à l'aide d'un algorithme génétique.

Pour cela, un premier aspect de l'invention concerne un procédé de détermination d'une cartographie CET caractérisant le temps de capture et d'émission des pièges dans un transistor pour une tension de stress donnée et une température donnée, dite cartographie CET optimale, cette détermination se faisant à partir d'une mesure expérimentale de l'évolution temporelle du changement de la tension de seuil $V_{TH}$ pour la même tension de stress et la même température et à partir d'une fonction de distribution des pièges, ladite fonction de distribution pouvant être définie par $N_{par}$ paramètres, ledit procédé comprenant :

- une phase d'initialisation comportant une étape de détermination de $N_{pop}$ vecteurs de dimension $N_{par}$, dite population initiale, les coordonnées de chaque vecteur correspondant à une valeur des paramètres de la fonction de distribution ;

- une phase de résolution comportant :

■ une étape de détermination de $N_{pop}$ vecteurs descendants, dite population descendante, cette étape comprenant au moins une sous-étape de croisement ou une sous-étape de mutation ;

■ une étape d'évaluation de chaque vecteur de la population initiale et de la population descendante à partir de la mesure expérimentale de l'évolution temporelle du changement de la tension de seuil de sorte à déterminer, pour chaque vecteur, un indicateur de l'ajustement entre l'évolution déterminée, pour une résolution de calcul de fixée, à partir du vecteur considéré et la mesure expérimentale de cette évolution ;

■ une étape de sélection parmi, les $2N_{pop}$ vecteurs de la population initiale et de la population descendante, les $N_{pop}$ vecteurs présentant le meilleur indicateur de l'ajustement ;

les étapes précédentes de la phase de résolution étant répétées successivement jusqu'à ce qu'une première condition d'arrêt fonction d'un nombre d'itération $N_{limit}$ et/ou du meilleur indicateur de l'ajustement soit atteinte, les $N_{pop}$ vecteurs sélectionnés lors de l'étape de sélection devenant la population initiale lors de chaque nouvelle itération ; une étape de sélection du vecteur présentant le meilleur indicateur de l'ajustement étant mise en œuvre lorsque cette première condition d'arrêt est atteinte ;

Grace à l'invention, il est donc possible d'automatiser, à l'aide d'un algorithme génétique, la détermination d'une cartographie. Pour mémoire, dans l'état de la technique, une telle carte était déterminée manuellement, ce qui rendait difficile toute comparaison entre des cartographies faites par différentes personnes, voire par la même personne sur différents échantillons. L'automatisation de cette tâche rend possible de telles comparaisons. Elle permet également la détermination d'une pluralité de cartographie pour des températures ou des tensions de stress différentes.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Dans un mode de réalisation, le procédé comprend également, après la phase de résolution, une phase d'affinement comportant au moins l'une des étapes suivantes :

- une étape de détermination d'une nouvelle population initiale fonction du vecteur présentant le meilleur indicateur d'ajustement obtenu lors de la phase de résolution précédente, la nouvelle population ayant un nombre de vecteur

$$N'_{pop} < N_{pop} \text{ ;}$$

- une étape d'augmentation de la résolution de calcul utilisée lors de l'étape d'évaluation de la phase de résolution ;

- une étape de modification de la première condition d'arrêt ;

la phase de résolution étant à nouveau mis en œuvre avec la nouvelle population initiale, la nouvelle résolution de calcul et la nouvelle première condition d'arrêt ; la phase de résolution et d'affinement étant itérées successivement jusqu'à qu'une deuxième condition d'arrêt fonction de l'indicateur d'ajustement du vecteur présentant le meilleur indicateur d'ajustement et du nombre d'itérations de la phase de résolution et de la phase d'affinement soit atteinte, la cartographie CET associée au vecteur présentant le meilleur indicateur d'ajustement étant alors sélectionnée comme cartographie CET optimale.

Dans un mode de réalisation, l'étape d'évaluation de la population initiale et de la population descendante comprend, pour chaque vecteur :

- une sous-étape de détermination, pour une résolution de calcul fixée, de la cartographie CET correspondant au vecteur considéré ;

- une sous-étape de détermination, à partir de la cartographie déterminée lors de la sous-étape précédente, de l'évolution temporelle du changement dans la tension de seuil ;

- une sous-étape de comparaison de l'évolution temporelle ainsi déterminée à la mesure expérimentale de l'évolution temporelle du changement dans la tension de seuil de sorte à déterminer un indicateur de qualité de l'ajustement entre l'évolution déterminée à partir du vecteur et la mesure expérimentale de cette évolution.

Dans un mode de réalisation, la fonction de distribution des pièges est définie à partir d'au moins une gaussienne, de préférence deux gaussiennes.

Dans un mode de réalisation, les coordonnées de chaque vecteur correspondent à une valeur des paramètres normalisés de la fonction de distribution.

Dans un mode de réalisation, l'étape de détermination de $N_{pop}$ vecteurs descendants comprend une sous-étape de croisement et une sous-étape de mutation.

Dans un mode de réalisation, la résolution utilisée pour l'étape d'évaluation est une résolution à pas adaptatif.

Un deuxième aspect de l'invention concerne un procédé de détermination de l'énergie d'activations d'un type de défauts dans un transistor, le procédé comprenant :

- pour une pluralité de températures, une étape de mise en œuvre d'un procédé selon un premier aspect de l'invention, de sorte à obtenir, pour chaque température de la pluralité de températures, une cartographie CET, la fonction de distribution étant identique pour chaque mise en œuvre et composée d'au moins une sous-distribution relative au type de défauts considéré, une pluralité de cartographies CET étant ainsi obtenue ;

- à partir de la pluralité de cartographies CET, une étape de détermination, en fonction de la température, de la position du maximum de la sous-distribution dans une représentation ayant pour abscisse le temps de capture et en ordonnée le temps d'émission ;

- à partir de l'évolution de la position du maximum de la sous-distribution relative à la population des défauts considéré, une étape de détermination de l'énergie d'activation du type de défauts considéré.

Un troisième aspect de l'invention concerne un dispositif de traitement de données comprenant des moyens configurés pour mettre en œuvre le procédé selon un premier aspect ou un deuxième aspect de l'invention.

Un quatrième aspect de l'invention concerne un programme d'ordinateur comprenant des instructions qui, lorsque le programme est exécuté par un ordinateur, conduisent celui-ci à mettre en œuvre le procédé selon un premier aspect ou un deuxième aspect de l'invention.

Un cinquième aspect de l'invention concerne un support de données lisible par ordinateur, sur lequel est enregistré le programme d'ordinateur selon le quatrième aspect de l'invention.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

La [Fig. 1] illustre le décalage de la tension de seuil induit par la présence de défauts.

La [Fig. 2] illustre la procédure dite Measurement-Stress-Measurement.

La [Fig.3] illustre le décalage de la tension de seuil en fonction de la durée de stress et de récupération.

Les [Fig. 4] à [Fig. 7] illustrent l'utilisation d'une cartographie CET pour la détermination du décalage de la tension de seuil en fonction de la durée de stress et la durée de récupération.

La [Fig. 8] montre un ordinogramme d'un procédé selon un premier aspect de l'invention.

La [Fig. 9] montre un exemple de distribution des défauts à partir de deux gaussiennes.

La [Fig. 10] illustre la valeur de l'erreur en fonction du nombre de gaussiennes $N_{Gauss}$ utilisées pour caractériser la distribution des défauts.

La [Fig. 11] montre une représentation schématique de la génération d'une population descendante à partir d'une population initiale.

La [Fig. 12] illustre une loi normale permettant de déterminer la nouvelle valeur d'un élément lors de la sous-étape de mutation.

La [Fig. 13] illustre la notion de la résolution de calcul pour une cartographie CET donnée.

La [Fig. 14] montre une représentation schématique de la sélection des vecteurs permettant d'obtenir le meilleur ajustement.

La [Fig. 15] montre une représentation schématique de la nouvelle population initiale composée par les vecteurs permettant d'obtenir le meilleur ajustement.

La [Fig. 16] montre un ordinogramme d'un procédé selon un deuxième aspect de l'invention.

La [Fig. 17] illustre l'évolution du maximum d'une sous-distribution associée à un type de défauts en fonction de la température.

La [Fig. 18] illustre la détermination de l'énergie d'activation des défauts.

## DESCRIPTION DETAILLEE

Sauf précision contraire, un même élément apparaissant sur des figures différentes présente une référence unique.

### Rappels sur la cartographie CET

Afin de comprendre l'invention, il va maintenant être rappelé comment il est possible de déterminer, à partir d'une cartographie CET, le décalage dans la tension seuil $V_{TH}$ en fonction de la durée du stress appliqué (pour une tension de stress donnée et une température donnée).

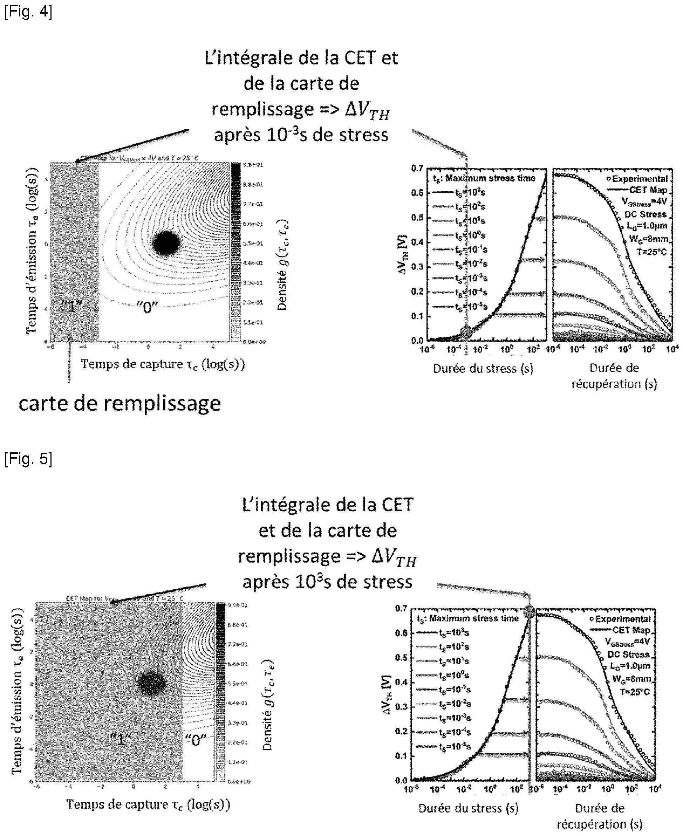

Pour rappel, comme illustré à la [Fig. 4] à gauche, une cartographie CET représente la densité de pièges en fonction du temps de capture en abscisse et du temps d'émission en ordonnée. Elle est établie pour une tension de stress donnée et une température donnée.

Une telle cartographie permet de déterminer le nombre de pièges activés en fonction de la durée de stress appliqué. Dans la [Fig. 4], un stress d'une durée de $10^{-3}s$ a été imposé et la zone grisée représente la région de la cartographie correspondant aux pièges activés pour une telle durée de stress, c'est-à-dire les pièges ayant un temps de capture inférieur ou égal à la durée du stress. En intégrant la densité sur la région ainsi identifiée, il est possible de remonter au nombre de pièges activés et, en supposant une contribution égale de tous les pièges dans le décalage de la tension de seuil $V_{TH}$, au décalage de tension de seuil $V_{TH}$ correspondant à une telle durée de stress ([Fig. 4] à droite). En répétant cette opération pour une pluralité de durées de stress (par exemple pour une durée de $10^{3}s$ à la [Fig. 5]), il est possible de reconstituer l'évolution du décalage de la tension de seuil $V_{TH}$ en fonction de cette durée (partie gauche du graphique à droite sur les [Fig. 4] et [Fig. 5]).

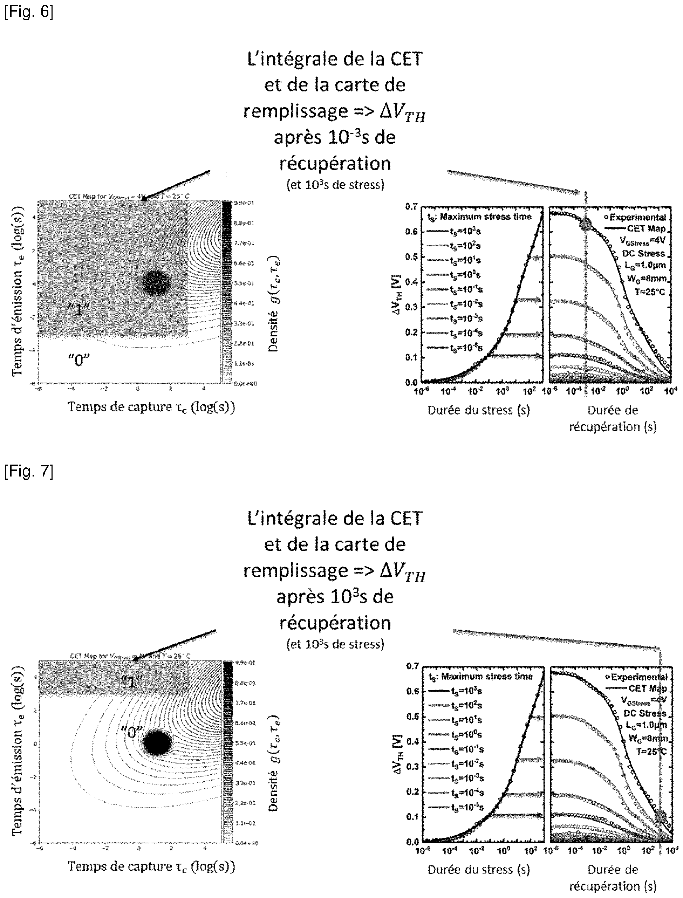

De manière similaire, il est possible, à partir de cette même cartographie CET, de remonter à l'évolution du nombre de pièges encore actifs après une durée sans application de stress, appelée dans la suite durée de récupération. Par exemple, comme illustré à la [Fig. 6], partant de la zone grisée correspondant à la durée maximale du stress appliqué, il est possible d'identifier la zone de la cartographie correspondant à des pièges qui sont encore actifs après $10^{-3}s$ de récupération, c'est-à-dire les pièges activés lors de l'application du stress et qui ont un temps d'émission supérieur à $10^{-3}s$ ([Fig. 6] à gauche). En intégrant la densité sur la région ainsi identifiée, il est possible de remonter au nombre de pièges encore actifs et, en supposant une contribution égale de tous les pièges dans le décalage de la tension de seuil $V_{TH}$, au décalage de tension de seuil $V_{TH}$ correspondant à une telle durée de récupération ([Fig. 6] à droite). En répétant cette opération pour un pluralité de durées de récupération (par exemple pour une durée de $10^{3}s$ à la [Fig. 7]), il est possible de reconstituer l'évolution du décalage de la tension de seuil $V_{TH}$ en fonction de la durée de récupération (partie droite du graphique à droite sur les [Fig. 6] et [Fig. 7]). En outre, comme le montre la pluralité de courbes sur la droite du graphique de droite des [Fig. 6] et [Fig. 7], il est possible d'effectuer un tel calcul pour différentes durées de stress (ici, neuf durées de stress différentes).

Il ressort donc de ce qui précède que la détermination d'une cartographie CET permet de remonter à l'évolution du décalage de la tension de seuil $V_{TH}$ en fonction de la durée du stress et de la durée de récupération. Cela signifie également qu'une cartographie CET peut être évaluée en comparant la prédiction de cette évolution déterminée à partir de la cartographie CET avec une mesure expérimentale de cette évolution, par exemple en fonction de la qualité de l'ajustement obtenu.

### Procédé de détermination d'une cartographie CET optimale

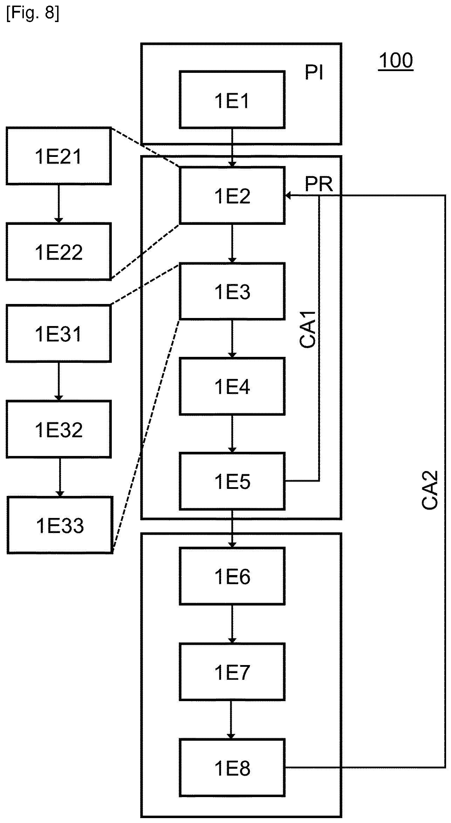

Un premier aspect de l'invention illustré à la [Fig. 8] concerne un procédé 100 de détermination d'une cartographie CET optimale, autrement dit une cartographie caractérisant le temps de capture et d'émission des pièges dans un dispositif semi-conducteur telle que présentée précédemment. Comme détaillé précédemment, une cartographie CET est relative à une tension de stress donnée et à une température donnée. Aussi, la détermination selon l'invention se fait pour une tension de stress donnée et une température donnée. Cependant, le procédé 100 de détermination d'une cartographie CET optimale pourra être répété pour plusieurs tensions de stress et/ou plusieurs températures de sorte à obtenir une pluralité de cartographies CET optimales, chaque cartographie CET optimale correspondant à une tension de stress donnée et une température donnée.

Afin de pouvoir déterminer cette cartographie CET optimale à l'aide d'un procédé 100 selon l'invention, il est nécessaire de disposer d'une mesure expérimentale de l'évolution temporelle du changement dans la tension de seuil $V_{TH}$ correspondant à la tension de stress donnée et à la température donnée, c'est-à-dire la tension de stress et la température pour lesquelles l'on souhaite déterminer la cartographie CET optimale. Comme évoquée plus haut, une telle mesure pourra être utilisée pour évaluer la prédiction de l'évolution temporelle du changement dans la tension de seuil $V_{TH}$ (ci-après prédiction) faite avec une cartographie CET donnée et retenir ou pas la cartographie ainsi évaluée. Les détails concernant cette évaluation seront donnés dans la suite. La mesure pourra par exemple être réalisée à l'aide de la technique Measurement-Stress-Measurement (pour mesure-stress-mesure) décrite en introduction de la description et bien connue de l'homme du métier (cf. [Fig. 2]).

La détermination se fait également à partir d'au moins une fonction de distribution des pièges, ladite fonction de distribution pouvant être caractérisée par $N_{par}$ paramètres. Pour une valeur donnée des paramètres $N_{par}$, cette distribution permet d'obtenir une cartographie CET qu'il conviendra ensuite d'évaluer. Ainsi, une cartographie CET est donnée par une fonction de distribution caractérisée par $N_{par}$ paramètres et par un jeu de valeurs desdits paramètres, représenté dans la suite par un vecteur de dimension $N_{par}$. Aussi, la fonction de distribution ne variant pas au cours du procédé, on parlera indifféremment de l'évaluation d'une cartographie CET ou de l'évaluation de la valeur des paramètres associée à cette dernière.

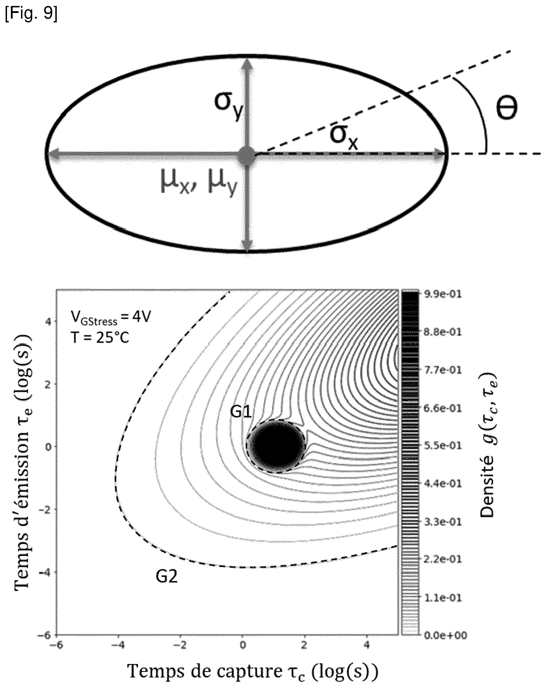

Dans un exemple de réalisation illustré à la [Fig. 9], la distribution est définie à l'aide de deux gaussiennes $G_1$, $G_2$. Chaque gaussienne est définie par les paramètres suivants : les coordonnées du centre de la gaussienne notées $\mu_x$ et $\mu_y$, les écart type notés $\sigma_x$ et $\sigma_y$, l'amplitude notée $A$ et l'orientation latérale notée $\theta$. Ainsi, chaque gaussienne est déterminée par six paramètres, et la distribution peut être caractérisée par $N_{par}$ paramètres avec $N_{par} = 2 \times 6 = 12$. De manière plus générale, lorsqu'une pluralité de gaussiennes est utilisée pour définir la distribution, alors $N_{par} = 6 \times N_{Gauss}$ où $N_{Gauss}$ est le nombre de gaussiennes utilisées.

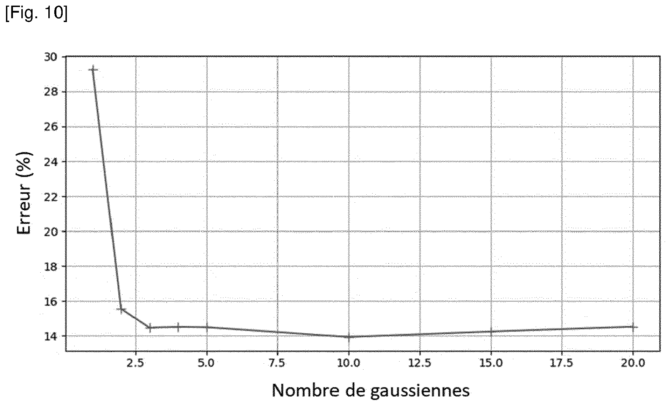

Cependant, plus le nombre de gaussiennes est grand, plus la puissance de calcul nécessaire à l'évaluation de chaque cartographie CET est grande. Or, un plus grand nombre de gaussiennes ne conduit pas nécessairement à l'amélioration de la précision dans la détermination de la cartographie CET comme le montre la [Fig. 10]. Cette figure illustre, pour un exemple particulier de matériau, la valeur de l'erreur (c'est-à-dire de la différence entre la prédiction faite avec la cartographie optimale déterminée à l'aide d'un procédé 100 selon l'invention et la mesure expérimentale) en fonction du nombre de gaussiennes $N_{Gauss}$ utilisées. Il ressort clairement de cette figure qu'un nombre de gaussiennes supérieur à trois n'améliore pas nécessairement la précision dans la détermination de la cartographie CET.

Dans un mode de réalisation, le nombre de gaussiennes utilisées est déterminé par le nombre de types de pièges (ou de populations de pièges) présents dans le matériau. Par exemple, si deux types de pièges sont présents (venant ainsi constituer deux populations de pièges), alors deux gaussiennes seront utilisées.

Dans un mode de réalisation, les gaussiennes utilisées sont des gaussiennes bidimensionnelle ayant la forme suivante :

[Math. 1]

$$G(x,y) = A \cdot exp\left[-\frac{1}{2} \cdot \left(\frac{(x - \mu_x) \cdot cos(\theta) - (y - \mu_y) \cdot sin(\theta)}{\sigma_x}\right)^2 - \frac{1}{2}\right.$$
$$\left. \cdot \left(\frac{(x - \mu_x) \cdot sin(\theta) + (y - \mu_y) \cdot cos(\theta)}{\sigma_y}\right)^2\right]$$

Bien entendu, d'autre fonctions peuvent être utilisées pour définir la fonction de distribution sans changer les principes énoncés ci-dessus. Par exemple, il est également possible d'utiliser une lorentziennes bidimensionnelles si l'on considère que les densités de pièges sont plus localisées :

[Math. 2]

$$L(x, y) = A \Big/ \left[ 1 + \left( \frac{(x-\mu_x) \cdot cos(\theta) - (y-\mu_y) \cdot sin(\theta)}{\sigma_x} \right)^2 + \left( \frac{(x-\mu_x) \cdot sin(\theta) + (y-\mu_y) \cdot cos(\theta)}{\sigma_y} \right)^2 \right]$$

Il est également possible d'utiliser pseudo fonction de Voigt qui se base sur combinaison linéaire des deux dernières fonctions, en rajoutant septième paramètre $\eta$ dans les paramètres $N_{par}$, et qui est définie par :

[Math. 3]

$$V(x, y) = \eta \cdot L(x, y) + (1 - \eta) \cdot G(x, y)$$

Cette dernière fonction présente l'avantage de permettre d'obtention d'un profil de distribution qui peut être Gaussien ($\eta$ = 0), Lorentzien ($\eta$ = 1) ou entre les deux (0 < $\eta$ < 1), ce qui permet d'améliorer l'ajustement et donc mieux reproduire les résultats expérimentaux. En revanche, cela demande d'ajuster un paramètre supplémentaire $\eta$, ce qui complexifie la convergence et requiert une puissance de calcul plus élevée, notamment du fait de la présence de deux fonctions à calculer (G et L).

*Phase d'initialisation*

Afin de déterminer une cartographie CET optimale, le procédé 100 selon l'invention comprend une phase d'initialisation PI comportant une étape 1E1 de détermination de $N_{pop}$ vecteurs de dimension $N_{par}$, dite population initiale, les coordonnées de chaque vecteur correspondant à une valeur des paramètres de la fonction de distribution, de préférence une valeur normalisée de ces derniers, et donc à une cartographie CET. Chaque cartographie CET ainsi obtenue n'est qu'une cartographie CET candidate, une seule cartographie CET (dite cartographie CET optimale) parmi ces dernières ou leurs descendantes sera retenue à la fin du procédé selon l'invention.
De préférence, lors de la phase d'initialisation PI, le nombre de vecteurs $N_{pop}$ est compris entre 500 et 1500, une telle valeur permettant d'obtenir un bon compromis entre le temps de calcul et le risque de déterminer une solution optimale correspondant en fait à un minium local.
Dans un mode de réalisation, les $N_{pop}$ vecteurs initiaux sont obtenus à l'aide d'une méthode d'échantillonnage par hypercube latin (ou LHS pour *Latin Hypercube Sampling* en anglais), par échantillonnage aléatoire (les coordonnées de chaque vecteur sont tirées aléatoirement) ou bien encore par échantillonnage orthogonal.
Comme déjà mentionné, plus le nombre de vecteurs $N_{pop}$ est grand, plus les chances de déterminer une solution optimale correspondant à un minimum local sont faibles. En revanche, un nombre de vecteurs $N_{pop}$ grand implique une puissance de calcul nécessaire à la détermination de la solution optimale élevée. Il y a donc un compromis à faire entre le nombre de vecteurs $N_{pop}$ et le risque de voir la détermination de la solution optimale aboutir à un minimum local. Comme on le verra par la suite, dans un mode de réalisation particulièrement avantageux, le procédé 100 selon l'invention permet de supprimer, ou au moins de limiter, un tel compromis en réduisant le nombre de vecteurs au fur et à mesure que le risque de voir la solution optimale correspondre à un minimum local diminue.

*Phase de résolution*

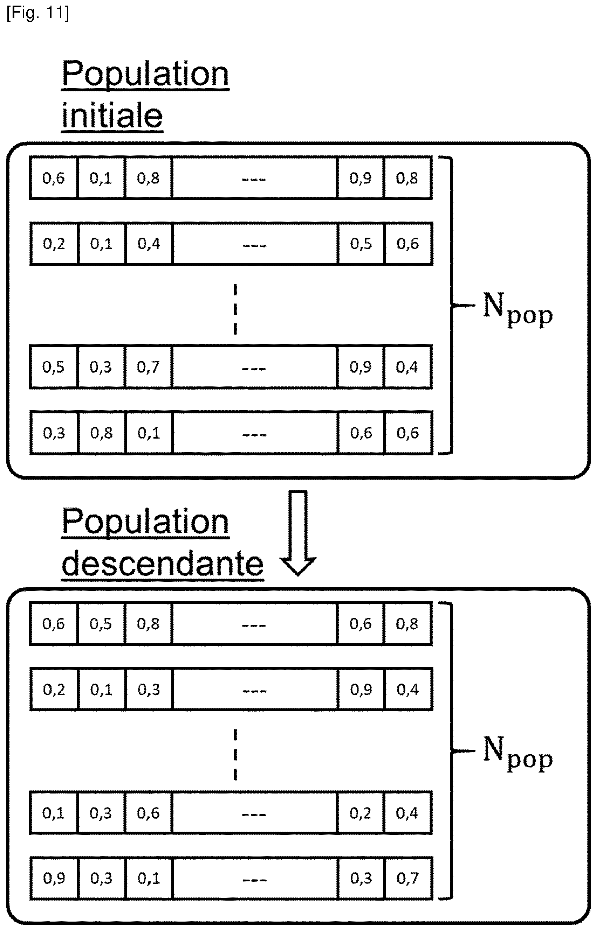

Le procédé 100 selon l'invention comprend également une phase de résolution PR. Lors de cette phase de résolution, une cartographie CET optimale provisoire présentant le meilleur accord avec les mesures expérimentales (par rapport à toutes les autres cartographies CET) va être déterminée à l'aide d'un algorithme génétique.
Pour cela, cette phase de résolution PR comporte une étape 1E2 de détermination de $N_{pop}$ vecteurs descendants, dite population descendante. Dans un mode de réalisation, cette étape 1E2 de détermination comprend au moins une sous-étape 1E21 de croisement ou une sous-étape 1E22 de mutation. Bien que connues des spécialistes des algorithmes génétiques, les étapes 1E21, 1E22 de croisement et de mutation vont maintenant être décrites. Une représentation schématique de l'étape 1E2 de détermination de $N_{pop}$ vecteurs descendants est proposée à la [Fig. 11]. Pour tout détail complémentaire, le lecteur pourra se référer à l'un des nombreux ouvrages sur le sujet, par exemple X. Yu and M. Gen, Introduction to Evolutionary Algorithms. Springer Science & Business Media, 2010.
Dans un exemple de réalisation, la première sous-étape 1E21 de croisement comprend la détermination de deux nouveaux vecteurs, dits vecteurs enfants, à partir de deux vecteurs de la population initiale, dit vecteurs parents.

Bien entendu, les coordonnées des vecteurs enfants ne sont pas déterminées au hasard, mais héritées des vecteurs parents. Par exemple, en notant $P_1$ le premier parent, $P_2$ le deuxième parent, $E_1$ le premier enfant et $E_2$ le deuxième enfant, les enfants peuvent être obtenus à l'aide de la relation suivante :

[Math. 4]

$$\begin{cases} E_1 = \alpha P_1 + (\mathbf{1} - \alpha)P_2 \\ E_2 = \alpha P_2 + (\mathbf{1} - \alpha)P_1 \end{cases}$$

avec $\alpha$ un vecteur de dimension $N_{par}$ dont les coefficient sont compris entre zéro (0) et un (1). On notera que $\mathbf{1}$ apparait en gras car il s'agit d'un vecteur de dimension $N_{par}$ dont tous les coefficients sont égaux à 1. Bien entendu, d'autres méthodes de croisement peuvent être utilisées et il ne s'agit donc là que d'un exemple permettant d'illustrer l'invention.

Les vecteurs impliqués dans chaque croisement peuvent être choisis de manière purement stochastique, mais également par le biais d'autres méthodes, comme la méthode dite de la "loterie biaisée" (ou roulette wheel en anglais), la méthode dite "élitiste", ou bien encore la méthode de la sélection par tournois. De préférence, la méthode utilisée est la méthode de la loterie biaisée.

Dans un exemple de réalisation, la deuxième sous-étape 1E22 de mutation comprend l'application aux vecteurs de la population initiale et/ou de la population descendante d'un changement aléatoire au niveau de l'une ou plusieurs de leurs coordonnées. Cette sous-étape 1E22 peut donc être effectuée après la sous-étape 1E21 de croisement auquel cas, elle sera de préférence mise en œuvre sur les vecteurs de la population descendante seulement. Cette deuxième sous-étape 1E22 peut également être mise en œuvre en lieu et place de la sous-étape 1E21 de croisement. De préférence, la sous-étape 1E21 de croisement et la sous-étape 1E22 de mutation sont toutes deux mises en œuvre.

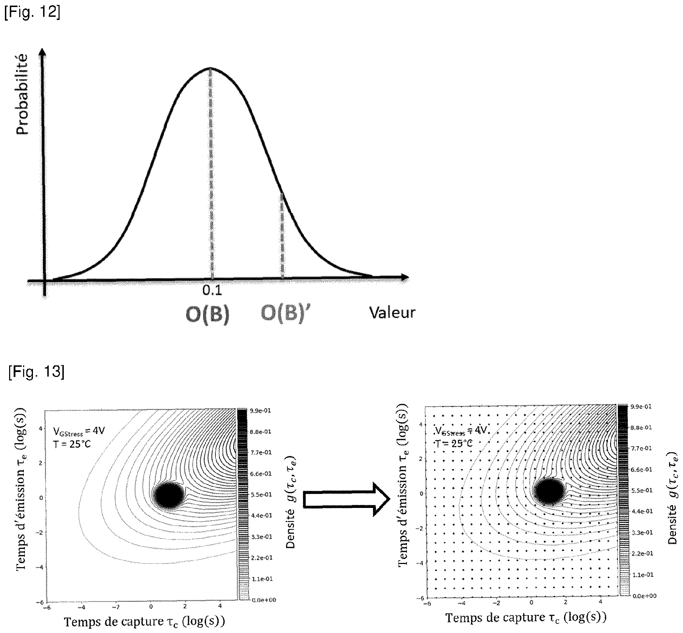

Lors de cette sous-étape 1E22 de mutation, chaque vecteur peut avoir une ou plusieurs de ses coordonnées modifiées. Dans un exemple de réalisation, la probabilité pour une coordonnée d'être modifiée est comprise entre 0.01 et 0.3, de préférence entre 0.01 et 0.05. De préférence, la probabilité de voir une valeur modifiée est choisie de sorte que la majorité des vecteurs (c'est-à-dire plus de 50% des vecteurs) n'ont qu'une seule coordonnée affectée lors de la mise en œuvre de la sous-étape 1E22 de mutation. Dans un mode de réalisation, lorsqu'une valeur est modifiée, la nouvelle valeur est tirée avec une probabilité qui suit une loi normale centrée sur la valeur avant modification (cf. [Fig. 12] où O(B) est la valeur initiale (dans cet exemple égale 0.1) et O(B)' est la nouvelle valeur, la courbe illustrant la loi normale utilisé pour déterminer cette nouvelle valeur).

La phase de résolution PR comporte également une étape 1E3 d'évaluation de chaque vecteur de la population initiale et de la population descendante à partir de la mesure expérimentale de l'évolution temporelle du changement dans la tension de seuil $V_{TH}$ de sorte à déterminer, pour chaque vecteur, un indicateur de qualité de l'ajustement entre l'évolution déterminée à partir du vecteur et la mesure expérimentale de cette évolution. Autrement dit, chaque cartographie CET (correspondant à un vecteur) est utilisée pour déterminer l'évolution temporelle du changement dans la tension de seuil $V_{TH}$ comme cela a été décrit précédemment. L'évolution ainsi déterminée est ensuite comparée aux mesures expérimentales de cette même évolution.

Comme illustré à la [Fig. 13], afin de pourvoir déterminer cette évolution, la cartographie CET est discrétisée, c'est-à-dire qu'elle n'est calculée que pour certaines valeurs des temps de capture et d'émission des pièges, les valeurs pour lesquelles la cartographie est calculée étant données par une résolution de calcul (donnée par les points noirs sur la [Fig. 13] à droite), cette résolution de calcul étant fixée pour une phase de résolution PR donnée. De manière préférentielle, la résolution de calcul est supérieure ou égale à 1 point par décade, voire 4 points par décade. Cependant, il est également possible d'effectuer les premières itérations de la phase de résolution PR (et donc de l'étape 1E3 d'évaluation) avec une résolution de calcul inférieure à cela.

Bien entendu, plus la résolution de calcul est élevée, meilleure est l'évaluation de la cartographie CET. Cependant, une résolution de calcul importante nécessite une puissance de calcul importante et/ou des temps de calcul longs. Aussi, le choix de la résolution de calcul nécessite de faire un compromis entre la précision dans l'évaluation de la cartographie CET et la puissance de calcul nécessaire pour cette évaluation. Il sera montré dans la suite que, dans un mode de réalisation particulièrement avantageux, le procédé 100 selon l'invention permet de supprimer, ou au moins de réduire, ce compromis en modifiant la résolution de calcul au cours des différentes itérations de la phase de résolution PR.

Dans un mode de réalisation, l'étape 1E3 d'évaluation comprend une sous-étape 1E31 de détermination, pour une résolution de calcul fixée, de la cartographie CET correspondant au vecteur considérée. Elle comprend également une sous-étape 1E32 de détermination, à partir de la cartographie CET ainsi déterminée, de l'évolution temporelle du changement dans la tension $V_{TH}$ de seuil (la méthode permettant cette détermination a déjà été introduite et est illustrée aux [Fig. 4] à [Fig. 7]). Elle comprend en outre une sous-étape 1E33 de comparaison de l'évolution temporelle du changement dans la tension de seuil $V_{TH}$ déterminée à l'aide de la cartographie CET considérée et de la mesure expérimentale de cette évolution de sorte à déterminer un indicateur de qualité de l'ajustement ces deux évolutions. Ainsi, plus l'évolution temporelle du changement dans la tension de seuil $V_{TH}$ déterminée à l'aide de la cartographie CET considérée est proche de la mesure expérimentale, plus l'indicateur de qualité de l'ajustement est faible.

Dans un exemple de réalisation, l'indicateur de qualité de l'ajustement est déterminé à l'aide de l'expressions suivante (correspondant à une méthode des moindres carrés) :

[Math. 6]

$$E = \sqrt{\sum_{i=1}^{n}\left(Y_{obs,i} - Y_{model,i}\right)^2 \Big/ n}$$

où $E$ est l'indicateur de qualité de l'ajustement, n est le nombre de points expérimentaux considérés, $Y_{obs,i}$ est la valeur de la i$^{\text{ème}}$ valeur expérimentale et $Y_{model,i}$ est la valeur déterminée à l'aide de cartographie CET correspondante.

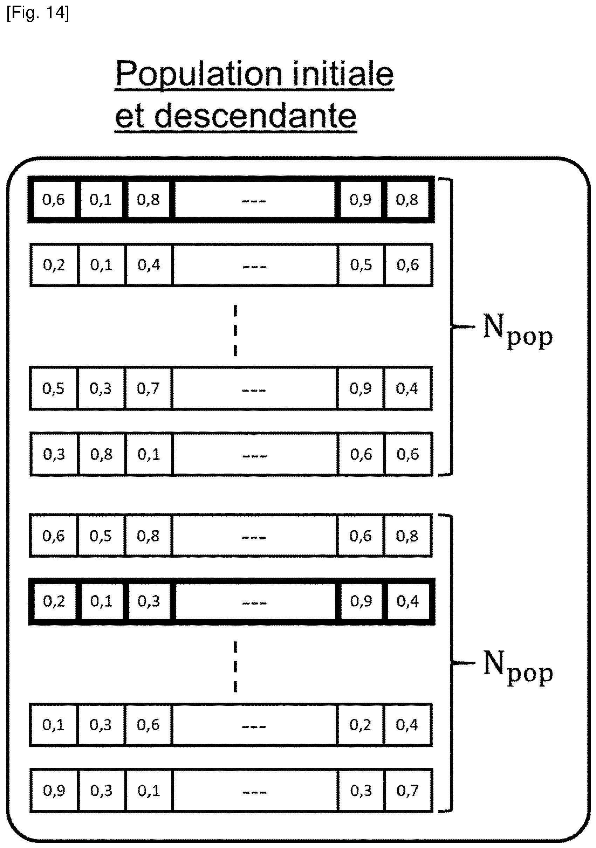

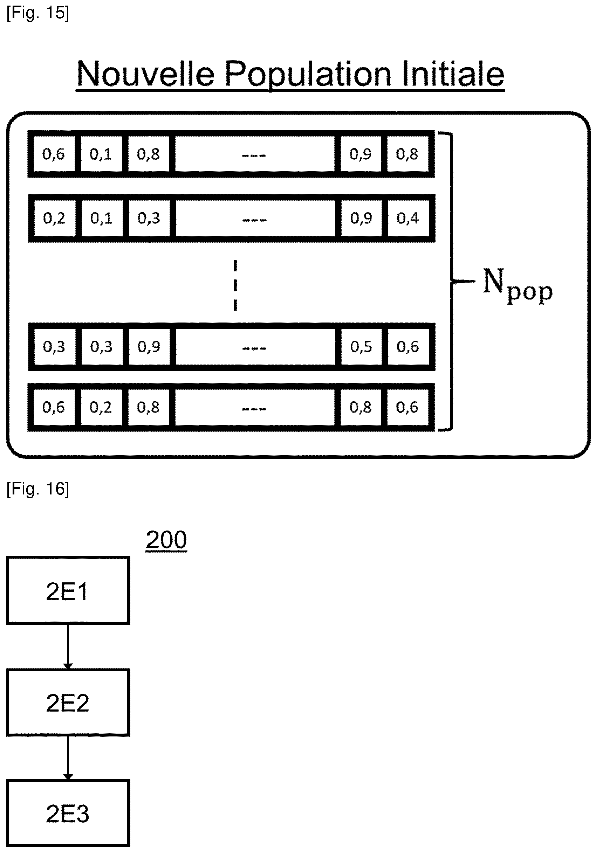

A l'issue de l'étape d'évaluation 1E3, il est possible de comparer les vecteurs entre eux en fonction de la qualité de l'ajustement déterminée pour chacun d'eux et de sélectionner les vecteurs présentant le meilleur ajustement. Pour cela, le procédé selon l'invention comprend une étape 1E4 de sélection parmi les $2N_{pop}$ vecteurs de la population initiale ($N_{pop}$ vecteurs) et de la population descendante ($N_{pop}$ vecteurs), les $N_{pop}$ vecteurs présentant le meilleur indicateur de l'ajustement. Une illustration de cette étape est proposée à la [Fig. 14] dans laquelle les vecteurs sélectionnés apparaissent en gras. Comme illustré à la [Fig. 15], ces vecteurs sélectionnés viendront ensuite constituer la nouvelle population initiale pour la prochaine itération des étapes précédentes.

Les étapes 1 E2, 1 E3, 1 E4 sont répétées jusqu'à qu'une première condition d'arrêt CA1 fonction d'un nombre d'itérations $N_{limit}$ et/ou du meilleur indicateur de l'ajustement soit atteinte, les $N_{pop}$ vecteurs sélectionnés lors de l'étape 1E4 de sélection devenant la population initiale lors de chaque nouvelle itération.

Dans un mode de réalisation, la première condition d'arrêt CA1 est atteinte lorsque, en valeur absolue, la différence entre le meilleur indicateur de l'ajustement de l'itération précédente et le meilleur indicateur de l'ajustement de l'itération actuelle est inférieure à un seuil prédéterminé. Cette condition présente l'avantage de ne pas poursuivre la résolution si aucune amélioration significative de l'indicateur de l'ajustement n'est observée entre les itérations successive. En revanche, il est possible qu'un plateau soit atteint avant qu'une amélioration arrive par la suite. Dans un tel cas, la condition d'arrêt précédente présente le risque de mettre un terme prématuré à la détermination de la cartographie optimale temporaire.

Dans un mode de réalisation, la première condition d'arrêt CA1 est atteinte lorsque le nombre d'itérations est égale à $N_{limit}$ et, de préférence, $N_{limit}$ est compris entre 500 et 5000.

Dans un mode de réalisation, la première condition d'arrêt CA1 est atteinte lorsque (condition A) le nombre d'itérations est égale à $N_{limit}$ ou bien lorsque (condition B) le nombre d'itérations est supérieur ou égal à $N'_{limit} < N_{limit}$ et lorsque (condition C), en valeur absolue, la différence entre le meilleur indicateur de l'ajustement de l'itération précédente et le meilleur indicateur de l'ajustement de l'itération actuelle est inférieure à un seuil prédéterminé (c'est-à-dire A ou (B et C)).

Lorsque la première condition d'arrêt CA1 est atteinte, le procédé selon l'invention comporte une étape E5 de sélection des coordonnées du vecteur présentant le meilleur indicateur de l'ajustement. Ainsi, la phase de résolution permet de déterminer un vecteur dont les coordonnées correspondent à une cartographie CET permettant un bon accord entre la tension de seuil $V_{TH}$ déterminée à l'aide de ladite cartographie CET et celle mesurée expérimentalement, dite cartographie CET optimale temporaire. Bien entendu, lorsque la phase optionnelle qui va maintenant être décrite n'est pas mise en œuvre cette cartographie CET optimale temporaire est considérée comme la cartographie CET optimale.

*La phase d'affinement (optionnel)*

Dans un mode de réalisation, afin d'affiner encore la détermination de la cartographie CET, le procédé 100 selon l'invention comprend également une troisième phase, dite phase d'affinement PA. Cette phase PA vise à déterminer une nouvelle résolution de calcul, une nouvelle population et/ou une nouvelle première condition d'arrêt CA1 pouvant être utilisées lors d'une nouvelle itération de la phase de résolution PR. En particulier, en réduisant la population de la phase de résolution PR et/ou en réduisant le nombre d'itérations lors de la phase de résolution PR, il est possible d'augmenter la résolution de calcul lors de la phase de résolution PR, par exemple pour atteindre une résolution pour laquelle une cartographie CET est jugée significative.

Dans un mode de réalisation, cette phase PA d'affinement comporte une étape 1E6 de détermination d'une nouvelle population initiale fonction du vecteur présentant le meilleur indicateur d'ajustement obtenu lors de la phase PR de résolution précédente, la nouvelle population ayant un nombre de vecteur $N'_{pop} < N_{pop}$ avec $N_{pop}$ le nombre de vecteurs utilisés dans l'itération précédente de la phase PR de résolution. La population ainsi obtenue est réduite par rapport à la population de la phase PR de résolution précédente. Cette réduction de la taille de la population est rendue possible par le fait que cette population est déterminée à partir d'un vecteur permettant d'obtenir un accord relativement bon avec les mesures expérimentales, ce qui limite le risque de voir cette réduction de la taille de la population conduire à un minimum local.

Dans un mode de réalisation, cette phase PA comporte une étape 1E7 d'augmentation de la résolution de calcul utilisée lors de l'étape 1E3 d'évaluation de la phase de résolution PR. Dans un exemple de réalisation, lors de cette étape 1E7, cette résolution de calcul est augmentée de 1 point/décade de temps. Bien entendu, il ne s'agit que d'un exemple et cette augmentation pourra être plus élevée dans d'autres cas. De préférence, cette étape est mise en œuvre lorsqu'une étape 1E6 de détermination d'une nouvelle population initiale est également mise en œuvre. Ainsi, la population étant réduite lors de l'étape 1E6 de détermination d'une nouvelle population, il est possible d'augmenter la résolution utilisée pour le calcul de la cartographie CET.

Il est également possible de modifier la première condition d'arrêt CA1 utilisée lors de la phase de résolution afin de pouvoir mettre en œuvre l'itération suivante de la phase de résolution RP avec une résolution de calcul plus élevée. Aussi, dans un mode de réalisation, la phase d'affinement comprend également une étape 1E8 de modification de la première condition d'arrêt CA1.

Dans un mode de réalisation, le nombre d'itération maximale $R_{limit}$ est calculé en fonction du nombre d'itération maximal défini lors de la phase d'initialisation PI et noté $N_{limit}^{initial}$ , par exemple à l'aide de l'expression suivante :

[Math. 7]

$$N_{limit} = N_{limit}^{initial}/R^n$$

où R est la résolution de calcul par décade utilisée et *n* est un facteur de décroissante fixé. Dans un mode de réalisation, n est un entier compris entre 1 (inclus) et 5 (inclus). De préférence, n est égal à 1. Bien entendu, $N_{limit}$ étant un entier, seul l'arrondi ou la partie entière du résultat ainsi obtenue sera pris en compte.

Ainsi, à l'issue de la phase d'affinement PA, une nouvelle résolution, une nouvelle population et/ou une nouvelle condition d'arrêt ont été déterminées et peuvent être utilisées lors d'une nouvelle itération de la phase de résolution PR. Aussi, à l'issue de la phase d'affinement PA, la phase de résolution PR est à nouveau mis en œuvre avec la nouvelle résolution, la nouvelle population initiale et/ou la nouvelle condition d'arrêt.

Ainsi, dans ce mode de réalisation, la phase de résolution PR et d'affinement PA sont itérées successivement jusqu'à qu'une deuxième condition d'arrêt CA2 fonction de la résolution de calcul. Dans un mode de réalisation, la deuxième condition est vérifiée lorsque la résolution de calcul atteinte est égale à une résolution de calcul souhaitée notée $R_{max}$. Dans un mode de réalisation, la résolution de calcul souhaitée $R_{max}$ est la résolution à atteindre pour que les cartographie CET extraites soient significatives. Dans un mode de réalisation, une cartographie CET est considérée comme significative lorsque sa résolution est supérieure ou égale à 7 points/décade de temps, préférentiellement supérieure ou égale à 10 points/décade de temps, voire supérieure ou égale à 15 points/décade de temps, voir même supérieure ou égale à 20 points/décade de temps. Une fois cette deuxième condition d'arrêt CA2 atteinte, la cartographie CET associée au vecteur présentant le meilleur indicateur d'ajustement étant alors sélectionnée comme cartographie CET optimale.

Le procédé 100 selon l'invention permet donc d'automatiser, à l'aide d'un algorithme génétique, la détermination d'une cartographie CET. Pour mémoire, dans l'état de la technique, une telle carte était déterminée manuellement, ce qui rendait difficile toute comparaison entre des cartographies CET faites par différentes personnes, voire par la même personne sur différents échantillons. L'automatisation de cette tâche permise par le procédé 100 selon l'invention rend possible de telles comparaisons. De plus, la détermination manuelle d'une cartographie CET est très fastidieuse et donc très longue. Une telle cartographie est donc en général réalisée pour une température et une tension de stress donnée, mais très rarement pour plusieurs valeurs de ces paramètres. Encore une fois, l'automatisation de cette tâche permise par le procédé 100 selon l'invention rend possible la détermination d'une pluralité de cartographie CET pour des températures ou des tensions de stress différentes.

Une des applications possibles est la détermination de l'énergie d'activation de défauts à partir d'une pluralité de cartographie CET réalisées pour différentes températures.

**Procédé de détermination de l'énergie d'activations des défauts dans un transistor**

Pour cela un deuxième aspect de l'invention illustré à la [Fig. 16] concerne un procédé 200 de détermination de l'énergie d'activation d'un type de défauts dans un transistor.

Le procédé 200 selon un deuxième aspect de l'invention comprend, pour une pluralité de températures, une étape 2E1 de mise en œuvre d'un procédé 100 selon un premier aspect de l'invention, de sorte à obtenir, pour chaque température de la pluralité de températures, une cartographie CET. De plus, lors de cette étape 2E1, la fonction de distribution est identique pour chaque mise en œuvre. Elle est en outre composée d'au moins une sous-distribution relative au type de défauts considéré, une pluralité de cartographies CET étant ainsi obtenue. Dans l'exemple donnée à la [Fig. 9], la distribution est composée de deux sous-distribution sous la forme de deux gaussiennes, la première gaussienne étant relative à une première population de défauts (ou type de défauts) et la deuxième gaussienne étant relative à une deuxième population de défauts (ou type de défauts).

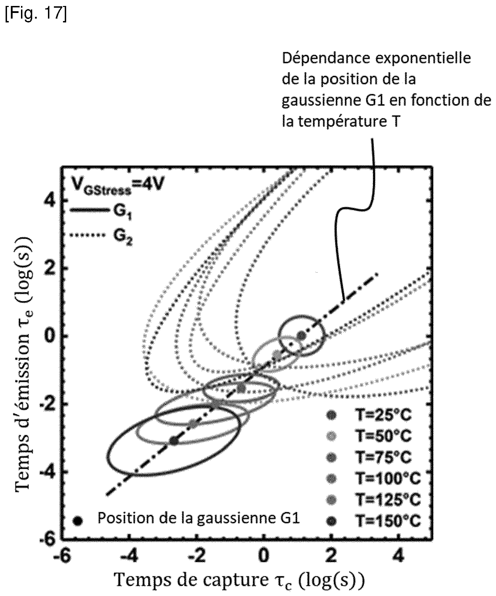

Le procédé 200 selon un deuxième aspect de l'invention comprend également, à partir de la pluralité de cartographies CET, une étape 2E2 de détermination, en fonction de la température, de la position du maximum de la sous-distribution dans une représentation ayant pour axes le temps de capture (par exemple en abscisse) et le temps d'émission (par exemple en ordonnée). Cette étape 2E2 est illustrée à la [Fig. 17] qui montre l'évolution d'une première gaussienne (notée G1) relative à un premier type de défauts et d'une deuxième gaussienne (notée G2) relative à un deuxième type de défauts en fonction de la température. De cette évolution, il est possible de suivre la position de chacune de ces sous-distributions en fonction de la température (voir la droite en pointillé pour l'évolution de la position du maximum de la première gaussienne G1).

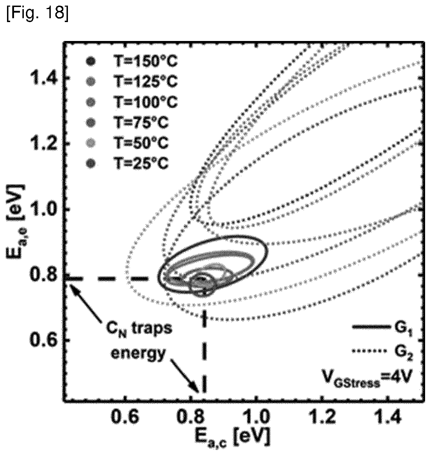

Enfin, le procédé 200 selon un deuxième aspect de l'invention comprend, à partir de l'évolution de la position du maximum de la sous-distribution relative à la population des défauts considérés, une étape 2E3 de détermination de l'énergie d'activation du type de défauts considéré. Cette détermination est illustrée à la [Fig. 18].

Plus particulièrement, les énergies d'activation sont obtenues en convertissant les échelles temporelles des différentes cartographies CET extraites vers des échelles en énergies d'activation. Cette conversion se fait par le biais de l'équation suivante :

[Math. 8]

$$\tau_{c/e} = \tau_0 \exp\left(\frac{E_{a,c/e}}{k_B T}\right)$$

Où $E_{a,c/e}$ est l'énergie d'activation associé à la capture ou à l'émission, $\tau_{c/e}$ est la constante de temps de capture ou d'émission, $k_B$ est la constante de Boltzmann, $T$ est la température et $\tau_0$ est déterminé en résolvant l'équation suivante :

[Math. 9]

$$\frac{T_1}{T_2} = \log\left(\frac{\tau_1}{\tau_0}\right) \Big/ \log\left(\frac{\tau_2}{\tau_0}\right)$$

Où $\tau_1$(respectivement $\tau_2$) est une constante de temps obtenue à la température $T_1$ (respectivement $T_2$) et $\tau_0$ est le temps tunnel élastique entre les pièges et les porteurs dans le semi-conducteur considéré.

Pour plus de détails, le lecteur pourra par exemple se référer aux documents suivants K. Puschkarsky, H. Reisinger, C. Schlünder, W. Gustin and T. Grasser, "Fast acquisition of activation energy maps using temperature ramps for lifetime modeling of BTI," 2018 48th European Solid-State Device Research Conférence (ESSDERC), Dresden, 2018, pp. 218-221, doi: 10.1109/ESSDERC.2018.8486855 ; et K. Puschkarsky, H. Reisinger, C. Schlünder, W. Gustin and T. Grasser, "Voltage-Dependent Activation Energy Maps for Analytic Lifetime Modeling of NBTI Without Time Extrapolation," in IEEE Transactions on Electron Devices, vol. 65, no. 11, pp. 4764-4771, Nov. 2018, doi: 10.1109/TED.2018.2870170.

**Dispositif de détermination d'une cartographie CET ou de l'énergie d'activation des défauts dans un transistor**

Le procédé 100,200 selon un premier aspect de l'invention ou un deuxième aspect de l'invention peut être mis en œuvre par un dispositif comprenant un moyen de calcul (par ex. un processeur) associé à une mémoire sur laquelle sont stockées les instructions et les données nécessaires à la mise en œuvre du procédé 100,200 considéré. Dans un mode de réalisation, le dispositif comprend également un moyen de saisie permettant à l'utilisateur de saisir les données nécessaires à la mise en œuvre du procédé 100,200 considéré. Dans un mode de réalisation, le dispositif comprend également un moyen d'affichage de sorte à pouvoir afficher la progression et/ou les résultats du procédé 100,200 considéré. Dans un mode de réalisation, le dispositif comprend également des moyens d'acquisition nécessaire à l'acquisition des données expérimentales utilisée lors de la mise en œuvre du procédé 100,200 considérée.

**Revendications**

1. Procédé (100) de détermination d'une cartographie CET caractérisant le temps de capture et d'émission des pièges dans un transistor pour une tension de stress donnée et une température donnée, dite cartographie CET optimale, cette détermination se faisant à partir d'une mesure expérimentale de l'évolution temporelle du changement de la tension de seuil $V_{TH}$ pour la même tension de stress et la même température et à partir d'une fonction de distribution des pièges, ladite fonction de distribution pouvant être définie par $N_{par}$ paramètres, ledit procédé comprenant :

   - une phase d'initialisation (PI) comportant une étape (1E1) de détermination de $N_{pop}$ vecteurs de dimension $N_{par}$, dite population initiale, les coordonnées de chaque vecteur correspondant à une valeur des paramètres de la fonction de distribution ;
   - une phase de résolution (PR) comportant :

      ○ une étape (1E2) de détermination de $N_{pop}$ vecteurs descendants, dite population descendante, cette étape comprenant au moins une sous-étape (1E21) de croisement et/ou une sous-étape (1E22) de mutation ;
      ○ une étape (1E3) d'évaluation de chaque vecteur de la population initiale et de la population descendante à partir de la mesure expérimentale de l'évolution temporelle du changement dans la tension de seuil de sorte à déterminer, pour chaque vecteur, un indicateur de l'ajustement entre l'évolution déterminée, pour une résolution de calcul fixée, à partir du vecteur considéré et la mesure expérimentale de cette évolution ;
      ○ une étape (1E4) de sélection parmi, les $2N_{pop}$ vecteurs de la population initiale et de la population descendante, les $N_{pop}$ vecteurs présentant le meilleur indicateur de l'ajustement ;

   les étapes précédentes de la phase de résolution étant répétées successivement jusqu'à ce qu'une première condition d'arrêt (CA1) fonction d'un nombre d'itération $N_{limit}$ et/ou du meilleur indicateur de l'ajustement soit atteinte, les $N_{pop}$ vecteurs sélectionnés lors de l'étape (1E4) de sélection devenant la population initiale lors de chaque nouvelle itération ; une étape (1E5) de sélection du vecteur présentant le meilleur indicateur de qualité de l'ajustement étant mise en œuvre lorsque cette première condition d'arrêt est atteinte.

2. Procédé selon la revendication précédente comprenant, à l'issue de la phase de résolution (PR), une phase d'affinement (PA) comportant au moins l'une des étapes suivantes :

   - une étape (1E6) de détermination d'une nouvelle population initiale fonction du vecteur présentant le meilleur indicateur d'ajustement obtenu lors de la phase de résolution précédente, la nouvelle population ayant un nombre de vecteur $N'_{pop} < N_{pop}$ ;
   - une étape (1E7) d'augmentation de la résolution de calcul utilisée lors de l'étape (1E3) d'évaluation de la phase de résolution ;
   - une étape (1E8) de modification de la première condition d'arrêt (CA) ;

   la phase de résolution (PR) étant à nouveau mis en œuvre avec la nouvelle population initiale, la nouvelle résolution de calcul et/ou la nouvelle première condition d'arrêt (CA1) ; la phase de résolution (PR) et d'affinement (PA) étant itérées successivement jusqu'à qu'une deuxième condition d'arrêt (CA2) fonction de la résolution de calcul utilisée lors de l'itération de la phase de résolution (PR), la cartographie CET associée au vecteur présentant le meilleur indicateur d'ajustement étant alors sélectionnée comme cartographie CET optimale.

3. Procédé (100) selon l'une des deux revendications précédentes dans lequel l'étape d'évaluation (1E3) de chaque vecteur de la population initiale et de la population descendante comprend, pour chaque vecteur :

 - une sous-étape (1E31) de détermination, pour une résolution de calcul fixée, de la cartographie CET correspondant au vecteur considérée ;
 - une sous-étape (1E32) de détermination, à partir de la cartographie déterminée lors de la sous-étape précédente (1E31), de l'évolution temporelle du changement dans la tension de seuil ;
 - une sous-étape (1E33) de comparaison de l'évolution temporelle ainsi déterminée à la mesure expérimentale de l'évolution temporelle du changement dans la tension de seuil de sorte à déterminer un indicateur de qualité de l'ajustement entre l'évolution déterminée à partir du vecteur et la mesure expérimentale de cette évolution.

4. Procédé (100) selon l'une des revendications précédentes dans lequel la fonction de distribution des pièges est définie à partir d'au moins une gaussienne, de préférence deux gaussiennes.

5. Procédé (100) selon l'une des revendications précédentes dans lequel les coordonnées de chaque vecteur de la population initiale et de la population descendante correspondent à une valeur des paramètres normalisés de la fonction de distribution.

6. Procédé (100) selon l'une des revendications précédentes dans lequel l'étape de détermination de $N_{pop}$ vecteurs descendants comprend une sous-étape de croisement et une sous-étape de mutation.

7. Procédé (100) selon l'une des revendications précédentes dans lequel la résolution utilisée pour l'étape (1E3) d'évaluation est une résolution à pas adaptatif.

8. Procédé (200) de détermination de l'énergie d'activations d'un type de défauts dans un transistor, le procédé comprenant :

 - pour une pluralité de températures, une étape (2E1) de mise en œuvre d'un procédé selon l'une des revendications précédentes, de sorte à obtenir, pour chaque température de la pluralité de températures, une cartographie CET, la fonction de distribution étant identique pour chaque mise en œuvre et composée d'au moins une sous-distribution relative au type de défauts considéré, une pluralité de cartographies CET étant ainsi obtenue ;
 - à partir de la pluralité de cartographies CET, une étape (2E2) de détermination, en fonction de la température, de la position du maximum de la sous-distribution dans une représentation ayant pour abscisse le temps de capteur et en ordonnée le temps d'émission ;
 - à partir de l'évolution de la position du maximum de la sous-distribution relative à la population des défauts considéré, une étape (2E3) de détermination de l'énergie d'activation du type de défauts considéré.

9. Dispositif de traitement de données comprenant des moyens configurés pour mettre en œuvre le procédé selon l'une des revendications précédentes.

10. Programme d'ordinateur comprenant des instructions qui, lorsque le programme est exécuté par un ordinateur, conduisent celui-ci à mettre en œuvre le procédé selon l'une des revendications 1 à 8.

11. Support de données lisible par ordinateur, sur lequel est enregistré le programme d'ordinateur selon la revendication précédente.

[Fig. 1]

Décalage de la tension de seuil $V_{TH}$ induit
par les pièges de charge et obtenu après
l'application de $V_{GStess}$ pendant une
durée $t_{stress}$ à une période fixe T

[Fig. 2]

[Fig. 3]

[Fig. 4]

L'intégrale de la CET et de la carte de remplissage => $\Delta V_{TH}$ après $10^{-3}$s de stress

carte de remplissage

[Fig. 5]

L'intégrale de la CET et de la carte de remplissage => $\Delta V_{TH}$ après $10^3$s de stress

[Fig. 6]

**L'intégrale de la CET et de la carte de remplissage => $\Delta V_{TH}$ après $10^{-3}$s de récupération**
(et $10^3$s de stress)

[Fig. 7]

**L'intégrale de la CET et de la carte de remplissage => $\Delta V_{TH}$ après $10^3$s de récupération**
(et $10^3$s de stress)

[Fig. 8]

[Fig. 9]

[Fig. 10]

[Fig. 11]

Population initiale

| 0,6 | 0,1 | 0,8 | --- | 0,9 | 0,8 |
| 0,2 | 0,1 | 0,4 | --- | 0,5 | 0,6 |
| 0,5 | 0,3 | 0,7 | --- | 0,9 | 0,4 |
| 0,3 | 0,8 | 0,1 | --- | 0,6 | 0,6 |

$N_{pop}$

Population descendante

| 0,6 | 0,5 | 0,8 | --- | 0,6 | 0,8 |
| 0,2 | 0,1 | 0,3 | --- | 0,9 | 0,4 |
| 0,1 | 0,3 | 0,6 | --- | 0,2 | 0,4 |
| 0,9 | 0,3 | 0,1 | --- | 0,3 | 0,7 |

$N_{pop}$

EP 4 060 719 A1

[Fig. 12]

[Fig. 13]

23

[Fig. 14]

# Population initiale et descendante

| 0,6 | 0,1 | 0,8 | --- | 0,9 | 0,8 |

| 0,2 | 0,1 | 0,4 | --- | 0,5 | 0,6 |

| 0,5 | 0,3 | 0,7 | --- | 0,9 | 0,4 |

| 0,3 | 0,8 | 0,1 | --- | 0,6 | 0,6 |

$N_{pop}$

| 0,6 | 0,5 | 0,8 | --- | 0,6 | 0,8 |

| 0,2 | 0,1 | 0,3 | --- | 0,9 | 0,4 |

| 0,1 | 0,3 | 0,6 | --- | 0,2 | 0,4 |

| 0,9 | 0,3 | 0,1 | --- | 0,3 | 0,7 |

$N_{pop}$

[Fig. 15]

## Nouvelle Population Initiale

| 0,6 | 0,1 | 0,8 | --- | 0,9 | 0,8 |
| 0,2 | 0,1 | 0,3 | --- | 0,9 | 0,4 |
| 0,3 | 0,3 | 0,9 | --- | 0,5 | 0,6 |
| 0,6 | 0,2 | 0,8 | --- | 0,8 | 0,6 |

$N_{pop}$

[Fig. 16]

200

2E1

2E2

2E3

[Fig. 17]

Dépendance exponentielle de la position de la gaussienne G1 en fonction de la température T

[Fig. 18]

Europäisches
Patentamt

European
Patent Office

Office européen
des brevets

# RAPPORT DE RECHERCHE EUROPEENNE

Numéro de la demande

**EP 22 16 2742**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | VIEY A G ET AL: "Carbon-related pBTI degradation mechanisms in GaN-on-Si E-mode MOSc-HEMT", 2020 IEEE INTERNATIONAL ELECTRON DEVICES MEETING (IEDM), IEEE, 12 décembre 2020 (2020-12-12), XP033885324, DOI: 10.1109/IEDM13553.2020.9371938 | 9 | INV. H01L21/66 G06N20/00 |
| A | * section IV; figures 13-17 * ----- | 1-8,10, 11 | |
| A | HANS REISINGER ET AL: "Understanding and modeling AC BTI", RELIABILITY PHYSICS SYMPOSIUM (IRPS), 2011 IEEE INTERNATIONAL, IEEE, 10 avril 2011 (2011-04-10), pages 6A.1.1-6A.1.8, XP031880826, DOI: 10.1109/IRPS.2011.5784542 ISBN: 978-1-4244-9113-1 * le document en entier * ----- | 1-11 | |
| A | GRASSER T ET AL: "Analytic modeling of the bias temperature instability using capture/emission time maps", ELECTRON DEVICES MEETING (IEDM), 2011 IEEE INTERNATIONAL, IEEE, 5 décembre 2011 (2011-12-05), pages 27.4.1-27.4.4, XP032096016, DOI: 10.1109/IEDM.2011.6131624 ISBN: 978-1-4577-0506-9 * le document en entier * ----- | 1-11 | DOMAINES TECHNIQUES RECHERCHES (IPC) H01L G06N |

-/--

Le présent rapport a été établi pour toutes les revendications

| Lieu de la recherche | Date d'achèvement de la recherche | Examinateur |
|---|---|---|
| Munich | 12 juillet 2022 | Ronnås, Katharina |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

**EP 22 16 2742**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | HANS REISINGER ET AL: "The statistical analysis of individual defects constituting NBTI and its implications for modeling DC and AC-stress", RELIABILITY PHYSICS SYMPOSIUM (IRPS), 2010 IEEE INTERNATIONAL, IEEE, PISCATAWAY, NJ, USA, 2 mai 2010 (2010-05-02), pages 7-15, XP031692365, ISBN: 978-1-4244-5430-3 * le document en entier * ----- | 1-11 | |
| A | WALTL M ET AL: "Superior NBTI in High-k SiGe Transistors-Part II: Theory", IEEE TRANSACTIONS ON ELECTRON DEVICES, IEEE, USA, vol. 64, no. 5, 1 mai 2017 (2017-05-01), pages 2099-2105, XP011646287, ISSN: 0018-9383, DOI: 10.1109/TED.2017.2686454 [extrait le 2017-04-20] * section V; figures 7, 9, 10 * ----- | 1-11 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 12 juillet 2022 | Ronnås, Katharina |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................................................
& : membre de la même famille, document correspondant

EPO FORM 1503 03.82 (P04C02)

page 2 de 2

# EP 4 060 719 A1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **X. YU ; M. GEN.** Introduction to Evolutionary Algorithms. Springer Science & Business Media, 2010
- **K. PUSCHKARSKY ; H. REISINGER ; C. SCHLÜNDER ; W. GUSTIN ; T. GRASSER.** Fast acquisition of activation energy maps using temperature ramps for lifetime modeling of BTI. *2018 48th European Solid-State Device Research Conférence (ESSDERC), Dresden,* 2018, 218-221
- **K. PUSCHKARSKY ; H. REISINGER ; C. SCHLÜNDER ; W. GUSTIN ; T. GRASSER.** Voltage-Dependent Activation Energy Maps for Analytic Lifetime Modeling of NBTI Without Time Extrapolation. *IEEE Transactions on Electron Devices,* Novembre 2018, vol. 65 (11), 4764-4771